# DEMANDE DE BREVET EUROPEEN

(11) **EP 4 040 120 A1**
(43) Date de publication de la demande: **10.08.2022**
(21) Numéro de dépôt: 22155683.0
(22) Date de dépôt: 08.02.2022
(51) Int. Cl.: G01J 1/02, G01J 1/04, G01J 1/42, H04N 5/369, H01L 27/146

(54) **ARCHITECTURE POUR PLAN FOCAL**

(30) Priorité: 09.02.2021 FR 2101210
(71) Demandeur: THALES, 92400 Courbevoie (FR)
(72) Inventeur: MARCON, Benoit, 06156 CANNES (FR); AURIBAULT, Romain, 06150 CANNES LA BOCCA (FR); FER, Yann, 06156 CANNES (FR)
(74) Mandataire: Marks & Clerk France

(57) **Abrégé**

L'invention concerne une architecture pour plan focal s'étendant selon une première surface (21), comprenant :
- un cadre mécanique (11) ;
- une pluralité de sous-platines (12), adjacentes deux à deux, s'étendant selon une deuxième surface (22), chacune de la pluralité de sous-platines (12) étant reliée au cadre mécanique (11), chacune de la pluralité de sous-platines (12) comprenant au moins deux détecteurs (13), chaque détecteur s'étendant selon la première surface (21) et étant disposé selon un alignement au moins partiel avec les détecteurs (13) de ladite sous-platine et de la sous-platine adjacente ;
- une pluralité d'éléments de découplage thermique (17) disposés entre chacune de la pluralité de sous-platines (12) et le cadre mécanique (11);
- au moins un drain thermique (15) relié à chacune de la pluralité de sous-platines (12).

## Description

La présente invention se situe dans le domaine des satellites d'observation de très haute résolution spatiale, plus précisément en mode push-broom et nécessitant une fauchée instantanée de plusieurs dizaines de milliers de pixels. L'invention se rapporte à une architecture pour former un plan focal c'est-à-dire un aménagement d'un plan focal formé par une pluralité de détecteurs.

Le domaine d'application de l'invention est celui des grands plans focaux (supérieurs à 600mm dans la direction de la fauchée instrument) emportant des capteurs d'image dissipatifs (supérieurs à 3W chacun) et nécessitant une très bonne stabilité mécanique et thermoélastique (inférieure à 5µm entre deux points quelconques), avec des détecteurs qui peuvent être allumés/éteints de manière intempestive, générant ainsi une dissipation potentiellement instable, du cyclage thermique, et donc des déformées thermoélastiques d'une ampleur inacceptable sur une architecture classique.

La fonction principale d'une architecture pour plan focal est de supporter de nombreux détecteurs nécessaires à l'obtention de la fauchée instantanée tout en prenant en compte les contraintes de performance exigée et d'environnement propre à l'utilisation d'un tel équipement. En mode push-broom, un capteur linéaire enregistre des images 1D et utilise le défilement du satellite autour de la Terre pour construire des bandeaux d'image. L'image est construite dynamiquement en prélevant des échantillons séquentiellement d'une ligne de balayage à une autre. Un alignement d'éléments photosensibles, appelés ici détecteurs, constitue le système de détection. La largeur d'une ligne de balayage est appelée fauchée instantanée.

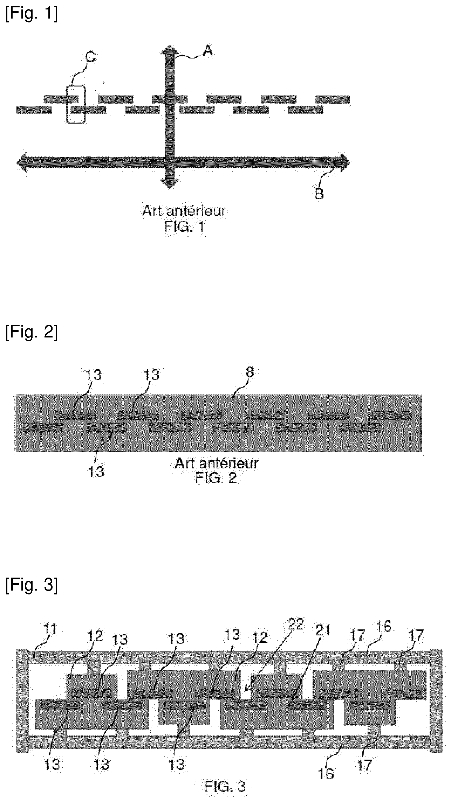

La figure 1 représente schématiquement une structure classique d'aménagement de détecteurs multilinéaires sur un plan focal d'instrument haute résolution selon l'art antérieur. La flèche référencée A indique la direction du défilement de l'image sur le plan focal liée au fonctionnement en mode push-broom. La flèche référencée B indique la direction de la fauchée instrument. Enfin la zone référencée C indique une zone de superposition entre pixels pour éviter les trous dans le champ.

Les problématiques majeures en lien avec ce type d'architecture sont nombreuses. Parmi elles, nous pouvons citer l'aboutage en ligne d'un grand nombre de détecteurs avec superposition de pixels à l'interface entre les détecteurs (ceci afin d'assurer qu'il n'y a aucun « trou » dans la fauchée). Le positionnement relatif de tous les pixels doit être réalisé avec une précision de l'ordre de la dimension des pixels. La stabilité relative de tous les pixels doit être meilleure que la dimension du pixel. En outre, pour des raisons d'aménagement, il faut pouvoir garantir une proximité de quelques centimètres entre les détecteurs et le boitier électronique qui va assurer la gestion des détecteurs. Idéalement, il faut également avoir la possibilité de permettre un bon niveau de flexibilité dans le développement du produit pour adresser des plans focaux de différentes dimensions.

A cela s'ajoutent des contraintes associées, et notamment la grande dimension (métrique) de l'ensemble du fait du grand nombre de détecteurs requis. Il faut alors faire face à une forte dissipation thermique des détecteurs et des éléments électroniques associés aux détecteurs dans une masse et un volume disponibles contraints

Enfin, les environnements mécaniques sont sévères à cause des évènements du lanceur.

Une architecture pour plan focal connue de l'art antérieur est représentée à la figure 2. Cette solution propose de monter les détecteurs sur une platine monolithique d'un matériau ayant une très bonne stabilité à la fois mécanique (raideur élevée) et thermique (coefficient de dilatation thermique faible).

Une conséquence de cette solution avec une unique platine monolithique est que le drainage thermique de la puissance dissipée par les détecteurs est réalisé par la platine elle-même.

Des céramiques à très faible Coefficient Thermo Elastique (CTE) et forte conductance thermique sont donc habituellement utilisées pour cette fonction à la fois thermique et mécanique.

Enfin, le positionnement des détecteurs est réalisé au niveau de la platine complète, et pour garantir une coplanarité suffisante (quelques dizaines de microns) des surfaces actives des détecteurs, une cale réalisée sur-mesure est fabriquée pour chaque détecteur. Cette cale dégrade les performances thermiques (en rajoutant des interfaces thermiques), complexifie et rallonge la durée l'intégration (étapes de montage des cales sur les détecteurs).

Comme évoqué ci-dessus, l'augmentation de la dimension de la platine et l'augmentation de la dissipation thermique des détecteurs liée aux nouvelles générations de puces CMOS vont naturellement aboutir à une dégradation des performances géométriques, et en particulier de la stabilité relative de positionnement des pixels. En effet, un plus grand nombre de détecteurs positionnés sur la platine génère une plus grande énergie thermique qui doit être dissipée par la platine. Celle-ci est amenée à chauffer et à se dilater. Il en résulte alors des problèmes de tenue mécanique et de performance. La dilatation de la platine fait bouger les pixels des détecteurs les uns par rapport aux autres. Les images générées par des détecteurs sont déformées dans le temps, créant ainsi des artéfacts.

De plus, les capacités d'augmentation des tailles de platines sont limitées par les moyens industriels (taille des fours de frittage de céramique notamment) déjà en limite pour la génération actuelle de plan focal.

Un autre aspect à considérer est qu'une dilatation thermique supérieure de la platine va également entraîner une déformation hors du plan focal, pouvant générer des phénomènes de défocalisation locale dégradant significativement la qualité du produit image final.

Enfin, un nouvel instrument nécessitant une fauchée différente nécessite un nouveau développement de platine et donc une phase de développement complète (incluant de nouvelles analyses mécaniques et thermiques).

De tout cela, il ressort que la solution actuelle de positionnement de détecteurs sur une unique platine monolithique assurant un rôle de tenue mécanique et de dissipation thermique a atteint ses limites.

Le document "Multispectral focal plane assembly for satellite remote sensing" (Rienstra et al.) décrit un ensemble de plan focal multispectral pour la télédétection par satellite. D1 divulgue la décomposition du plan focal en une pluralité de sous-platines. Toutefois, sur la disposition des détecteurs, pour chaque sous-platine, les détecteurs sont alignés.

Le document FR 3 040 777 A1 décrit un ensemble de détection optique comportant un détecteur optique à contrôle thermique amélioré. Le document FR 3 040 777 A1 ne donne pas de solution au fait que la stabilité thermoélastique sur une pièce monolithique de plus 600mm n'est pas gérable avec un fort niveau de dissipation des détecteurs car l'échauffement de la platine d'1 degré d'une platine en SiC (CTE de 4 environ) va engendrer une dilatation de 2,4µm, ce qui limiterait à 2°C l'élévation de température acceptable pour atteindre 5µm. La performance en stabilité d'une platine assemblée sur des barres céramiques isolées telle que présentée est à la fois indépendante de la dimension du plan focal et de l'échauffement des platines (et donc de la dissipation des détecteurs). De plus, le document FR 3 040 777 A1 ne donne pas de solution à une personne n'ayant pas les moyens de production d'une platine SiC (ou autres matériaux ayant la même performance de conductivité thermique / CTE) de très grande dimension.

L'invention vise à pallier tout ou partie des problèmes cités plus haut en proposant une nouvelle architecture pour plan focal basée sur la séparation de la fonction de stabilité thermoélastique globale du plan focal et de la fonction de drain thermique. Cette nouvelle architecture présente en outre l'avantage d'être complètement modulable en termes de nombre de pixels sans pour autant nécessiter un nouveau développement complet pour une nouvelle fauchée.

A cet effet, l'invention a pour objet une architecture pour plan focal s'étendant selon une première surface, caractérisée en ce qu'elle comprend :
- un cadre mécanique ;
- une pluralité de sous-platines, adjacentes deux à deux, s'étendant selon une deuxième surface, chacune de la pluralité de sous-platines étant reliée au cadre mécanique, chacune de la pluralité de sous-platines comprenant au moins deux détecteurs, chaque détecteur s'étendant selon la première surface et étant disposé selon un alignement au moins partiel avec les détecteurs de ladite sous-platine et de la sous-platine adjacente ;
- une pluralité d'éléments de découplage thermique disposés entre chacune de la pluralité de sous-platines et le cadre mécanique;
- au moins un drain thermique relié à chacune de la pluralité de sous-platines.

Avantageusement, le cadre mécanique comprend deux barres céramiques monolithiques sensiblement parallèles entre elles, la pluralité d'éléments de découplage thermique étant disposée entre les deux barres céramiques monolithiques et la pluralité de sous-platines.

Avantageusement, les éléments de découplage thermique sont des isolants thermiques et sont souples de sorte à absorber un déplacement relatif entre la pluralité de sous-platines et le cadre mécanique.

Avantageusement, le cadre mécanique comprend en outre deux éléments de fermeture, chacun reliant une extrémité d'une première des deux barres céramiques monolithiques à une extrémité d'une seconde de deux barres céramiques monolithiques.

Dans un mode de réalisation de l'invention, la première surface est une surface plane et les détecteurs sont orientés le long d'une courbe.

Dans un autre mode de réalisation de l'invention, la deuxième surface est une surface gauche.

Dans un autre mode de réalisation de l'invention, les détecteurs sont orientés le long d'une courbe, sensiblement parallèle à la deuxième surface.

Avantageusement, l'architecture pour plan focal selon l'invention comprend au moins une pièce disposée entre une sous-platine et un détecteur, ladite pièce étant de forme complémentaire à un interstice entre la surface supérieure de ladite sous-platine et la surface inférieure dudit détecteur.

L'invention concerne aussi un procédé de fabrication d'une architecture pour plan focal s'étendant selon une première surface, caractérisé en ce qu'il comprend les étapes suivantes:
- Fourniture d'un cadre mécanique ;
- Fourniture d'une pluralité de sous-platines,
- Pour chacune de la pluralité de sous-platines, alignement au moins partiel sur ladite sous-platine d'au moins deux détecteurs selon la première surface,
- Alignement de la pluralité de sous-platines selon une deuxième surface, adjacentes deux à deux, chaque détecteur d'une sous-platine étant au moins partiellement aligné avec un détecteur de la sous-platine adjacente et disposition d'une pluralité d'éléments de découplage thermique entre chacune de la pluralité de sous-platines et le cadre mécanique ;
- Connexion d'un drain thermique à chacune de la pluralité de sous-platines.

L'invention sera mieux comprise et d'autres avantages apparaîtront à la lecture de la description détaillée d'un mode de réalisation donné à titre d'exemple, description illustrée par le dessin joint dans lequel :
[Fig.1] La figure 1 représente schématiquement une structure classique d'aménagement de détecteurs multilinéaires sur un plan focal d'instrument haute résolution selon l'art antérieur;
[Fig.2] La figure 2 représente schématiquement une architecture classique de détecteurs disposés sur une unique platine monolithique selon l'art antérieur ;
[Fig.3] La figure 3 représente schématiquement le principe d'architecture pour plan focal selon l'invention;
[Fig.4] La figure 4 représente schématiquement une sous-platine de l'architecture pour plan focal selon l'invention;
[Fig.5] La figure 5 représente schématiquement l'architecture pour plan focal selon l'invention;
[Fig.6] La figure 6 représente schématiquement en vue de dessus un mode de réalisation de l'architecture pour plan focal selon l'invention, mode de réalisation permettant de prendre en compte un éventuel profil de distorsion imposé par l'optique ;
[Fig.7] La figure 7 représente schématiquement un mode de réalisation de l'architecture pour plan focal s'étendant selon une surface plane selon l'invention;
[Fig.8] La figure 8 représente schématiquement un mode de réalisation de l'architecture pour plan focal s'étendant selon une surface gauche selon l'invention;
[Fig.9] La figure 9 représente schématiquement un autre mode de réalisation de l'architecture pour plan focal s'étendant selon une surface gauche selon l'invention;
[Fig. 10] La figure 10 représente les étapes d'un procédé de fabrication d'une architecture pour plan focal selon l'invention.

Par souci de clarté, les mêmes éléments porteront les mêmes repères dans les différentes figures. Pour une meilleure visibilité et dans un souci de compréhension accrue, les éléments ne sont pas toujours représentés à l'échelle.

La figure 1 représente schématiquement une structure classique d'aménagement de détecteurs multilinéaires sur un plan focal d'instrument haute résolution selon l'art antérieur. Elle a été présentée dans l'introduction.

La figure 2 représente schématiquement une architecture classique de détecteurs disposés sur une unique platine monolithique selon l'art antérieur. Elle a été présentée dans l'introduction.

La figure 3 représente schématiquement le principe d'architecture pour plan focal selon l'invention. Dans l'architecture selon l'invention, le plan focal s'étend selon une première surface 21. Selon l'invention, l'architecture comprend un cadre mécanique 11 et une pluralité de sous-platines 12, adjacentes deux à deux, s'étendant selon une deuxième surface 22 correspondant à la surface focale image de l'optique. Cette deuxième surface 22 est préférentiellement sensiblement parallèle à la première surface 21, mais pas nécessairement. Chacune de la pluralité de sous-platines 12 est reliée au cadre mécanique 11. Chacune de la pluralité de sous-platines 12 comprend au moins deux détecteurs 13, chaque détecteur des au moins deux détecteurs de chacune de la pluralité de sous-platines s'étendant selon la première surface 21, formant ainsi le plan focal, et étant disposé selon un alignement au moins partiel avec les détecteurs 13 de ladite sous-platine et de la sous-platine adjacente selon la surface 22. En outre, l'architecture selon l'invention comprend une pluralité d'éléments de découplage thermique 17 disposés entre chacune de la pluralité de sous-platines 12 et le cadre mécanique 11. Enfin, l'architecture comprend un ou plusieurs drain thermique 15 relié à chacune de la pluralité de sous-platines 12 (non représenté sur la figure 3).

La première surface 21 est propre à chaque sous-platine, que l'on aligne à la deuxième surface 22 qui peut être dénominée comme une surface « d'ensemble » correspondant à la surface focale image de l'optique, chaque surface 21 ou 22 pouvant être plane ou « gauche », comme cela sera expliqué plus loin.

Contrairement à une architecture de l'art antérieur dans laquelle les détecteurs sont disposés sur une seule platine, l'architecture selon l'invention repose sur une pluralité de sous-platines 12. Autrement dit, le plan focal est décomposé en une pluralité de sous-platines élémentaires.

On peut préciser que la figure 3 représente trois détecteurs 13 par sous-platine 12. Une sous-platine peut n'avoir que deux détecteurs 13 ou bien plus que deux ou trois, par exemple quatre ou cinq, ou plus.

Le cadre mécanique 11 comprend deux barres 16 céramiques monolithiques sensiblement parallèles entre elles, la pluralité d'éléments de découplage thermique 17 étant disposée entre les deux barres 16 céramiques monolithiques et la pluralité de sous-platines 12.

Comme on le voit sur la figure 3, les détecteurs 13 sont alignés deux à deux, avec une zone de superposition entre pixels pour éviter les trous dans le champ. Le positionnement des détecteurs, en particulier le positionnement relatif entre deux pixels des détecteurs sur le plan focal, doit être extrêmement stable dans le temps afin de garantir la qualité des images nécessaire aux missions d'observation de haute résolution. Cette stabilité est typiquement inférieure à la dimension d'un pixel, soit de l'ordre de 3µm à 10µm environ.

La dissipation des détecteurs eux-mêmes réchauffe la platine qui se déforme sous l'effet de la dilatation thermoélastique. Cette déformation est une source majeure d'instabilité et l'ampleur de la dissipation est directement liée au niveau de dissipation des détecteurs, aux matériaux impliqués dans l'assemblage du plan focal, et en particulier leur coefficient de dilatation thermique et leur conductance, à la dimension des différents éléments.

Dans l'invention, la décomposition du plan focal en plusieurs sous-platines 12 et la structure du cadre mécanique 11 qui ne remplit pas, à lui seul, le rôle de support des détecteurs ont un effet synergique : grâce à ces deux particularités de l'invention, la partie thermique de l'architecture est isolée de la partie mécanique. Il en résulte un double avantage. D'une part, le cadre mécanique ne chauffe pas car il est isolé thermiquement des détecteurs qui fournissent de l'énergie thermique en fonctionnement. Il n'y a donc pas de déformation du cadre. D'autre part, la dilatation des éléments de l'architecture est moindre. En effet, comme l'ensemble est découpé en plusieurs sous-platines, chaque sous-platine peut faire l'objet d'une dilatation locale qui est maîtrisée. La performance de stabilité géométrique est proportionnelle à la dissipation des détecteurs et à la dimension de la platine. Grâce à une dissipation maîtrisée et une dimension de sous-platine plus petite, la stabilité géométrique de l'architecture est assurée. Ceci est d'autant plus important que la nouvelle génération d'instrument va utiliser des détecteurs dont la dissipation est significativement supérieure du fait de leur performance accrues, et un besoin en dimension de platine également supérieur du fait de la fauchée et de la résolution recherchée.

Avantageusement, les éléments de découplage thermique 17 sont des isolants thermiques et sont souples de sorte à absorber un déplacement relatif entre la pluralité de sous-platines 12 et le cadre mécanique 11 due aux déformées thermoélastiques.

Un autre avantage de l'architecture selon l'invention est la modularité du nombre de sous-platines (et donc du nombre de pixels) portée par le cadre mécanique en fonction du besoin en fauchée de l'instrument associé, sans nécessiter un développement complet pour une nouvelle fauchée.

Enfin, l'invention facilite le procédé de fabrication d'une telle architecture puisqu'il n'est plus nécessaire de prévoir une platine de grandes dimensions. Il est en effet plus simple de fabriquer les deux barres céramiques. Cette simplicité accrue est liée à la géométrie globalement monodimensionnelle d'une barre céramique par rapport à une platine qui est d'une part plus adaptée à la géométrie des fours de frittage existants, mais également un frittage sous gravité simplifié.

L'invention apporte une solution technique à la triple tendance actuelle d'augmentation de la dimension du plan focal, de la dissipation des détecteurs, et de réduction des risques et durée de développement.

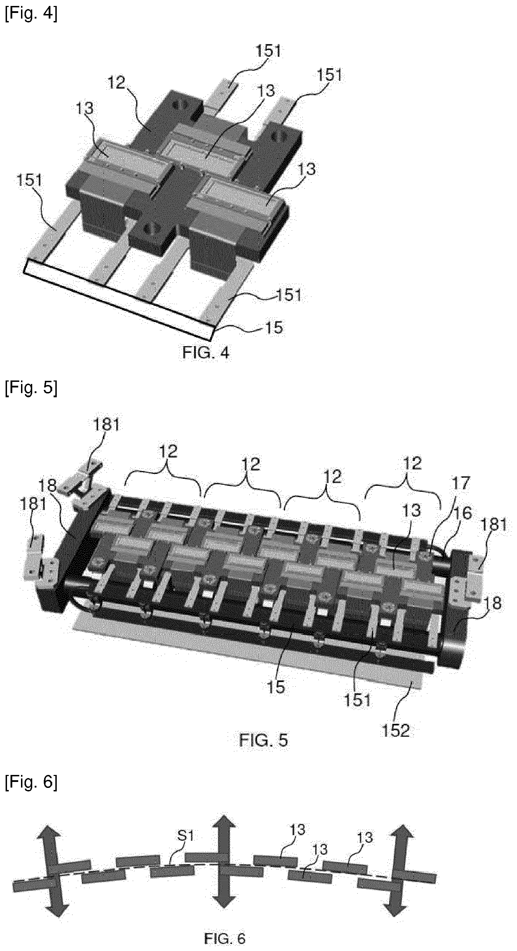

La figure 4 représente schématiquement une sous-platine 12 de l'architecture pour plan focal selon l'invention. Sur la sous-platine 12 sont disposés trois détecteurs 13. Il s'agit d'un exemple de disposition des détecteurs. Il pourrait y en avoir deux, ou plus que trois. Les détecteurs 13 sont disposés en étant au moins partiellement alignés entre eux. Autrement dit, une portion d'un des détecteurs 13 est alignée avec une autre portion d'un autre détecteur 13 de la même sous-platine 12. Les détecteurs 13 de plusieurs sous-platines 12 peuvent être alignés entre eux selon différents agencements comme cela sera expliqué ci-dessous.

Un drain thermique 15 est relié à la sous-platine 12. Le drain thermique 15 est ici représenté schématiquement dans un but explicatif. Le drain thermique 15 est relié à la sous-platine 12 par le biais d'une ou deux tresses thermiques 151 qui sont en contact direct avec la sous-platine 12. L'énergie thermique provenant de la sous-platine 12 peut ainsi être évacuée par les tresses thermiques 151 et le drain thermique 15.

La figure 5 représente schématiquement l'architecture pour plan focal selon l'invention. Plusieurs sous-platines 12 sont disposées pour former un plan focal selon la première surface. Grâce à la pluralité de sous-platines 12, l'architecture peut offrir une fauchée instantanée de taille variable facilement en adaptant le nombre de sous-platines 12. Les sous-platines sont adjacentes deux à deux, et s'étendent selon la deuxième surface (non représentée). Les sous-platines 12 sont reliées au cadre mécanique 11 par les éléments de découplage thermique 17 disposés entre chacune de la pluralité de sous-platines 12 et les deux barres 16 céramiques monolithiques du cadre mécanique 11. Les tresses thermiques 151 relient les sous-platines 12 au drain thermique 15. Le drain thermique 15 est, quant à lui, relié à un caloduc ou à un radiateur 152 permettant ainsi le transfert thermique adéquate.

Comme on peut le voir, le cadre mécanique 11 comprend les deux barres 16 céramiques monolithiques sensiblement parallèles entre elles, la pluralité d'éléments de découplage thermique 17 étant disposée entre les deux barres 16 céramiques monolithiques et la pluralité de sous-platines 12. Le cadre mécanique 11 comprend deux éléments de fermeture 18, chacune reliant une extrémité d'une première des deux barres 16 céramiques monolithiques à une extrémité d'une seconde de deux barres 16 céramiques monolithiques. En d'autres termes, le cadre mécanique de l'architecture pour plan focal est formé par une structure de type cadre permettant d'assurer la rigidité mécanique de l'ensemble.

Avantageusement, le cadre mécanique 11 comprend trois pieds de fixation 181 pour un montage isostatique de l'architecture sur la structure du télescope associé.

A titre d'exemple, et de manière non-limitative, les éléments de découplage thermique 17 peuvent être un ensemble formé par des boîtes à colle femelle et boîte à colle mâle avec élément de découplage souple à faible CTE, permettant de fixer les sous-platines 12 sur le cadre mécanique 11. Ces éléments 17 assurent l'isolation thermique et absorbent le déplacement lié à la dilatation thermo-élastique entre le cadre mécanique et les sous-platines.

La figure 6 représente schématiquement en vue de dessus un mode de réalisation de l'architecture pour plan focal selon l'invention, mode de réalisation permettant de prendre en compte un éventuel profil de distorsion imposé par l'optique. Dans ce mode de réalisation, la première surface 21 est une surface plane et les détecteurs 13 sont orientés le long d'une courbe, référencée S1. Selon les cas de figure, il peut être nécessaire de prendre en compte les aberrations optiques dans le plan et d'orienter les détecteurs 13 en conséquence. La distorsion engendre une évolution de la direction du défilement en fonction de la position dans le champ.

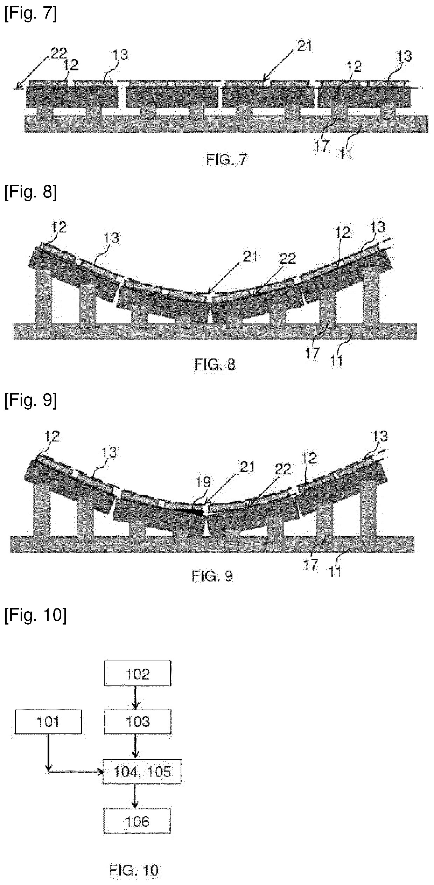

La figure 7 représente schématiquement un mode de réalisation de l'architecture pour plan focal s'étendant selon une surface plane selon l'invention. Dans ce mode de réalisation, la première surface 21 est une surface plane et les détecteurs 13 sont disposés selon la deuxième surface 22 plane également. On parle de solution aplanétique dans laquelle les pixels des détecteurs 13 sont coplanaires.

La figure 8 représente schématiquement un mode de réalisation de l'architecture pour plan focal s'étendant selon une surface gauche selon l'invention. Dans ce mode de réalisation, la première surface 21 est une surface gauche et les détecteurs 13 sont disposés selon la deuxième surface 22 gauche également. On parle de solution non-aplanétique. Il s'agit d'un alignement sur une surface théorique non planaire au niveau des sous-platines 12, les détecteurs 13 de chaque sous-platine 12 étant coplanaires au niveau de la sous-platine. Les détecteurs 13 d'une sous-platine 12 sont orientés le long d'une courbe, sensiblement parallèle à la deuxième surface 22, par rapport aux détecteurs 13 d'une autre sous-platine 12.

La figure 9 représente schématiquement un autre mode de réalisation de l'architecture pour plan focal s'étendant selon une surface gauche selon l'invention. Dans ce mode de réalisation, la première surface 21 est une surface gauche et les détecteurs 13 sont disposés selon la deuxième surface 22 gauche également. On parle de solution non-aplanétique. Dans ce cas, il s'agit d'un alignement sur une surface théorique non planaire au niveau des sous-platines 12, les détecteurs 13 de chaque sous-platine 12 étant eux aussi alignés sur la surface théorique. Dans ce cas, l'architecture comprend au moins une pièce 19 disposée entre une sous-platine 12 et un détecteur 13, ladite pièce 19 étant de forme complémentaire à l'interstice entre la surface supérieure de la sous-platine et la surface inférieure du détecteur assurant un alignement du détecteur sur la surface théorique.

La figure 10 représente les étapes d'un procédé de fabrication d'une architecture pour plan focal selon l'invention. Le procédé de fabrication d'une architecture pour plan focal s'étendant selon une première surface comprend les étapes suivantes:
- Fourniture (étape 101) d'un cadre mécanique 11 ;
- Fourniture (étape 102) d'une pluralité de sous-platines 12,
- Pour chacune de la pluralité de sous-platines 12, alignement (étape 103) au moins partiel sur ladite sous-platine 12 d'au moins deux détecteurs 13 selon la première surface 21,
- Alignement (étape 104) de la pluralité de sous-platines 12 selon une deuxième surface 22, adjacentes deux à deux, chaque détecteur 13 d'une sous-platine 12 étant au moins partiellement aligné avec un détecteur 13 de la sous-platine 12 adjacente et disposition (étape 105) d'une pluralité d'éléments 17 de découplage thermique entre chacune de la pluralité de sous-platines 12 et le cadre mécanique 11 ;
- Connexion (étape 106) d'un drain thermique 15 à chacune de la pluralité de sous-platines 12.

Les étapes 104 et 105 sont indissociables. En effet, la pièce permettant de découplage thermique est également la pièce permettant de maintenir les sous-platines en position par rapport au cadre mécanique. Il en résulte un alignement et fixation à travers les pièces 17.

Le procédé de fabrication selon l'invention se distingue des procédés de l'art antérieur notamment par la chronologie des étapes 103 et 104: d'abord les détecteurs 13 sont alignés, puis les sous-platines sont alignées.

L'intégration des sous-platines 12 peut être réalisée à l'aide d'hexapodes (assurant un positionnement au micromètre) et de boîtes à colles (permettant une liaison sans contraintes) pour apporter la précision de positionnement requise entre chaque sous-platine pour la constitution du plan focal complet (quelques dizaines de micromètres).

Le découplage thermique entre les sous-platines et les barres céramiques Si3N4 peut être effectué à l'aide des éléments 17 isolants à faible coefficient de dilatation thermoélastique pour minimiser les impacts des gradients thermiques liés à l'isolation sur la stabilité du plan focal. Typiquement ces liaisons sont en Invar ou en TA6V en fonction des besoins de performance de découplage (à titre d'exemple, entre 16W et 54W de dissipation par sous-platine en fonction du type de détecteurs) et de stabilité requise (quelques dizaines de micromètres).

Le découplage thermique peut être augmenté à l'aide de souplesses intégrées dans les éléments 17 de découplage thermique (éléments de fixation) pour à la fois minimiser les fuites thermiques et minimiser les déplacements induits dans les sous-platines dues aux effets thermoélastiques.

L'invention propose une architecture pour plan focal dans laquelle les détecteurs ne sont pas tous alignés sur une unique platine monolithique mais répartis sur plusieurs sous-platines stables. Ces sous-platines subissent des déformées thermoélastiques de plus faible amplitude par rapport à une platine monolithique (du fait de leur taille réduite et d'un drainage thermique plus efficace). De plus, les déformées thermoélastiques des sous-platines ne dépendent alors plus du nombre de détecteurs sur le plan focal, car ce paramètre est géré par rajout ou suppression de sous-platines. La performance de stabilité thermoélastique est donc constante quel que soit le nombre total de détecteurs sur le plan focal.

Les difficultés industrielles sont elles aussi réduites car l'étape critique d'intégration des détecteurs se fait sur une échelle réduite (celle d'une sous-platine).

Enfin la faisabilité de platine de très grande dimension est contournée par la réalisation de barres céramiques de grandes dimensions, préférentiellement en Si3n4, pour le cadre mécanique du plan focal. La stabilité de ces dernières étant garantie par l'isolation thermique entre les barres et les détecteurs et leur coefficient de dilatation thermique extrêmement faible.

Il apparaîtra plus généralement à l'Homme du métier que diverses modifications peuvent être apportées aux modes de réalisation décrits ci-dessus, à la lumière de l'enseignement qui vient de lui être divulgué. Dans les revendications qui suivent, les termes utilisés ne doivent pas être interprétés comme limitant les revendications aux modes de réalisation exposés dans la présente description, mais doivent être interprétés pour y inclure tous les équivalents que les revendications visent à couvrir du fait de leur formulation et dont la prévision est à la portée de l'Homme du métier se basant sur ses connaissances générales.

## Revendications

1. Architecture pour plan focal s'étendant selon une première surface (21), **caractérisée en ce qu'**elle comprend :
- un cadre mécanique (11) ;
- une pluralité de sous-platines (12), adjacentes deux à deux, s'étendant selon une deuxième surface (22), chacune de la pluralité de sous-platines (12) étant reliée au cadre mécanique (11), chacune de la pluralité de sous-platines (12) comprenant au moins deux détecteurs (13), chaque détecteur s'étendant selon la première surface (21) et étant disposé selon un alignement au moins partiel avec les détecteurs (13) de ladite sous-platine et de la sous-platine adjacente, et pour chaque sous-platine, une portion d'un parmi les au moins deux détecteurs (13) étant alignée avec une autre portion d'un autre détecteur parmi les au moins deux détecteurs (13) ;
- une pluralité d'éléments de découplage thermique (17) disposés entre chacune de la pluralité de sous-platines (12) et le cadre mécanique (11);
- au moins un drain thermique (15) relié à chacune de la pluralité de sous-platines (12).

2. Architecture pour plan focal selon la revendication 1, dans laquelle le cadre mécanique (11) comprend deux barres (16) céramiques monolithiques sensiblement parallèles entre elles, la pluralité d'éléments de découplage thermique (17) étant disposée entre les deux barres (16) céramiques monolithiques et la pluralité de sous-platines (12).

3. Architecture pour plan focal selon la revendication 2, dans laquelle les éléments de découplage thermique (17) sont des isolants thermiques et sont souples de sorte à absorber un déplacement relatif entre la pluralité de sous-platines (12) et le cadre mécanique (11).

4. Architecture pour plan focal selon la revendication 2, dans laquelle le cadre mécanique (11) comprend en outre deux éléments de fermeture (18), chacun reliant une extrémité d'une première des deux barres (16) céramiques monolithiques à une extrémité d'une seconde de deux barres (16) céramiques monolithiques.

5. Architecture pour plan focal selon l'une quelconque des revendications 1 à 4, dans laquelle la première surface (21) est une surface plane et les détecteurs (13) sont orientés le long d'une courbe.

6. Architecture pour plan focal selon l'une quelconque des revendications 1 à 4, dans laquelle la deuxième surface (22) est une surface gauche.

7. Architecture pour plan focal selon la revendication 6, dans laquelle les détecteurs (13) sont orientés le long d'une courbe, sensiblement parallèle à la deuxième surface (22).

8. Architecture pour plan focal selon la revendication 7, comprenant au moins une pièce (19) disposée entre une sous-platine (12) et un détecteur (13), ladite pièce (19) étant de forme complémentaire à un interstice entre la surface supérieure de ladite sous-platine (12) et la surface inférieure dudit détecteur (13).

9. Procédé de fabrication d'une architecture pour plan focal s'étendant selon une première surface, **caractérisé en ce qu'**il comprend les étapes suivantes:
- Fourniture (101) d'un cadre mécanique (11) ;
- Fourniture (102) d'une pluralité de sous-platines (12),
- Pour chacune de la pluralité de sous-platines (12), alignement (103) au moins partiel sur ladite sous-platine (12) d'au moins deux détecteurs (13) selon la première surface (21),
- Alignement (104) de la pluralité de sous-platines (12) selon une deuxième surface (22), adjacentes deux à deux, chaque détecteur (13) d'une sous-platine (12) étant au moins partiellement aligné avec un détecteur (13) de la sous-platine (12) adjacente, et pour chaque sous-platine, alignement d'une portion d'un parmi les au moins deux détecteurs (13) avec une autre portion d'un autre détecteur parmi les au moins deux détecteurs (13), et disposition (105) d'une pluralité d'éléments (17) de découplage thermique entre chacune de la pluralité de sous-platines (12) et le cadre mécanique (11) ;
- Connexion (106) d'un drain thermique (15) à chacune de la pluralité de sous-platines (12).
